(19) Europäisches Patentamt
European Patent Office
Office européen des brevets

(11) **EP 4 633 018 A1**

(12) **EUROPEAN PATENT APPLICATION**

(43) Date of publication:
**15.10.2025 Bulletin 2025/42**

(21) Application number: **25162508.3**

(22) Date of filing: **10.03.2025**

(51) International Patent Classification (IPC):
*H02M 1/00* (2006.01)    *H02M 1/08* (2006.01)
*H02M 1/32* (2007.01)    *H02M 7/219* (2006.01)
*H03K 17/082* (2006.01)

(52) Cooperative Patent Classification (CPC):
**H02M 1/0009; H02M 1/08; H02M 1/32;**
**H02M 7/219; H03K 17/0822**

(84) Designated Contracting States:
**AL AT BE BG CH CY CZ DE DK EE ES FI FR GB**
**GR HR HU IE IS IT LI LT LU LV MC ME MK MT NL**
**NO PL PT RO RS SE SI SK SM TR**
Designated Extension States:
**BA**
Designated Validation States:
**GE KH MA MD TN**

(30) Priority: **08.04.2024  GB 202404960**

(71) Applicant: **Rolls-Royce plc**
**London N1 9FX (GB)**

(72) Inventor: **Inventor, UK**
**Derby, DE24 8BJ (GB)**

(74) Representative: **Rolls-Royce plc**
**P.O. Box 31**
**IP Department (SinA-48)**
**Derby Derbyshire DE24 8BJ (GB)**

(54) **POWER ELECTRONICS CONVERTER**

(57)    A power electronics converter 1020 comprising: an input terminal; first and second DC output terminals 1003, 1004; a branch comprising first and second semiconductor switches connected in series between the first and second DC output terminals 1003, 1004, the input terminal connected to a node between the first and second semiconductor switches; a DC link capacitor 1008 connected between the first and second DC output terminals 1003, 1004; a differential current sensor 1009 arranged to measure a differential current signal through the first or second DC terminals 1003, 1004; and a controller 1040 configured to provide switching signals to each of the first and second switches of the power electronics converter 1020, wherein the controller 1040 is further configured to detect a fault in a DC network 1030 connected between the first and second DC output terminals 1003, 1004 upon detection of a peak in an output from the differential current sensor 1009.

FIG. 10

## Description

## TECHNICAL FIELD

This disclosure relates to power electronics converters for use in electrical power systems, which may be of particular utility in transport applications including, but not limited to, aerospace.

## BACKGROUND

In aerospace, aircraft and their power and propulsion systems are becoming increasingly electric in their design. So-called 'more electric engines' (MEEs) and 'more electric aircraft' (MEAs) may derive all or substantially all of their propulsive thrust from turbomachinery but make greater use of electrical power compared with conventional platforms. They may, for example, use electrical power to power auxiliary systems which have previously been powered mechanically or pneumatically, or may use spool-coupled electrical machines to transfer power to, from and between engine spools to provide improvements in engine operability and efficiency. In hybrid electric aircraft, the propulsive thrust is derived from engines (e.g., gas turbine engines) and from other sources, typically batteries and/or fuel cells which supply electrical power to engine- or propulsor-coupled electrical machines.

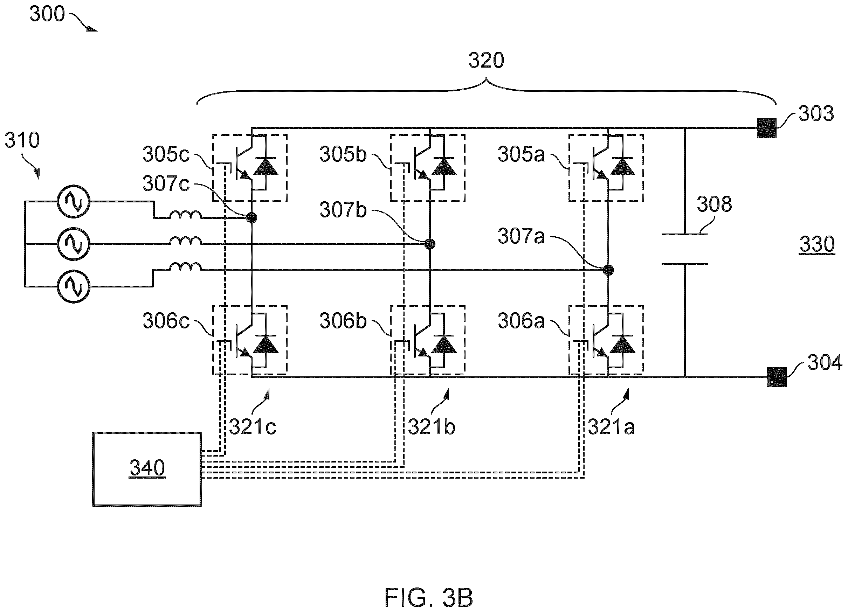

Some proposed platforms include DC electrical networks which receive electrical power from engine-driven electrical machines via AC to DC converters (i.e., rectifiers). FIG. 3B illustrates a typical arrangement in which a three-phase electrical generator 310, which may be coupled with and driven by a spool of a gas turbine engine, is connected with a DC network 330 via a two-level AC-DC converter 320.

In the event of a DC-side fault, the voltage across the DC terminals 303, 304 collapses and two components of fault current flow: a first due to the discharge the converter DC link capacitor 308 and a second from the AC side of the converter 320. The former may be very large and can damage the diodes of the converter 320, especially the so-called weak body diodes where MOSFETs are used.

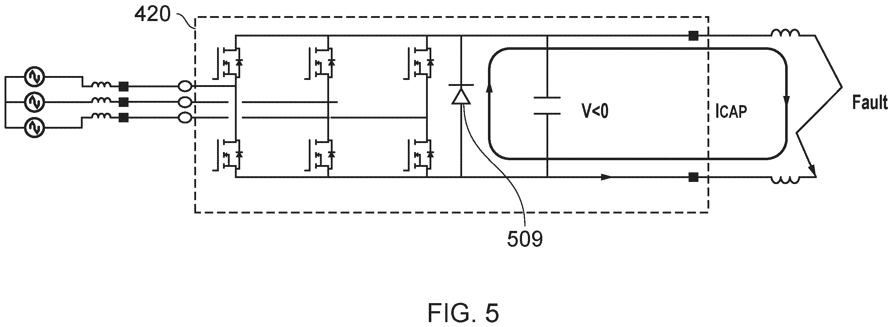

EP 4283851 A1 discloses several methods for protecting the diodes of a converter, one of which, shown in FIG. 5, involves connecting an additional diode across the DC terminals in parallel with the DC capacitor. This serves to protect the diodes of the converter against the high surge current stress delivered from the discharge of the DC link capacitor.

## SUMMARY

According to a first aspect, there is provided a power electronics converter comprising:

an input terminal;

first and second DC output terminals;

a branch comprising first and second semiconductor switches connected in series between the first and second DC output terminals, the input terminal connected to a node between the first and second semiconductor switches;

a DC link capacitor connected between the first and second DC output terminals;

a differential current sensor arranged to measure a differential current signal through the first or second DC terminals; and

a controller configured to provide switching signals to each of the first and second switches of the power electronics converter,

wherein the controller is further configured to detect a fault in a DC network connected between the first and second DC output terminals upon detection of a peak in an output from the differential current sensor above a first predetermined threshold and operate the first and second switches to prevent current flowing to the DC network.

The power electronics converter may further comprise a voltage sensor connected to measure a voltage across the DC output terminals, wherein the controller is configured to prevent current flowing to the DC network upon detection of the peak from the differential current sensor above the first predetermined threshold and upon detection from the voltage sensor of the voltage across the DC output terminals falling below a second predetermined threshold.

The second predetermined threshold may be around 75%, 60%, 50% or less of a nominal DC output voltage of the converter.

The controller may be further configured to open contactors to disconnect the DC network from the converter after detection of the peak from the differential current sensor and detection from the voltage sensor of the voltage across the DC output terminals falling below the second predetermined threshold.

The controller may be configured to operate the converter to turn on the semiconductor switches upon detection of the voltage across the DC output terminals falling below a third predetermined threshold lower than the second predetermined threshold.

The third predetermined threshold may be around 25% or less of a nominal DC output voltage of the converter.

The power electronics converter may further comprise an integrator connected to the differential current sensor and configured to output a measure of change in current through the first or second DC terminals, wherein the controller is configured to receive the measure of change in current and operate the first and second switches to prevent current flowing to the DC network upon detection of a peak in an output from the differential current sensor above a first predetermined threshold and if the measure of change in current is above a fourth predetermined threshold.

The differential current sensor may comprise a Rogowski coil.

According to a second aspect there is provided a power electronics converter comprising:

an input terminal;
first and second DC output terminals;
a branch comprising first and second semiconductor switches connected in series between the first and second DC output terminals, the input terminal connected to a node between the first and second semiconductor switches;
a DC link capacitor connected between the first and second DC output terminals; and
first and second drain-source measurement circuits connected to measure a drain-source voltage of the respective first and second semiconductor switches and output a control signal for the respective semiconductor switch if the measured drain-source voltage has a negative value greater than a predetermined voltage threshold; and
first and second gate driver circuits is connected to a gate and source of the respective first and second semiconductor switches and configured to provide a gate driving signal to turn on the respective first and second semiconductor switches upon receiving the control signal from the respective drain-source measurement circuit.

Each drain-source measurement circuit may comprise a voltage measurement circuit configured to measure the drain-source voltage across the respective semiconductor switch and a comparator having an inverting first input connected to receive an output from the voltage measurement circuit, a non-inverting second input connected to receive a negative voltage source and an output connected to provide the control signal to the gate driving circuit if the output from the voltage measurement circuit has a negative value greater than the predetermined voltage threshold from the negative voltage source.

The predetermined voltage threshold may be around -9V or greater.

The power electronics converter according to the first or second aspects may further comprise a reverse-biased DC link diode connected across the DC link capacitor.

In some examples, the first and second semiconductor switches may each comprise a transistor connected in anti-parallel with a diode. The transistor may be an IGBT or MOSFET.

In some examples, the first and second semiconductor switches may each consist of a MOSFET, i.e., with no diode connected in parallel. In such examples, the current capacity of the DC link diode is greater than that of the body diode of each MOSFET, for example between around 5 and 10 times greater.

Where the power electronics converter is an AC to DC converter, the power electronics converter may comprise a plurality of said branches connected between the first and second DC output terminals, the node between the first and second semiconductor switches of each branch being connectable to a respective phase of an electrical machine.

The power electronics converter may have a single branch for each phase, in which the second input terminal is connected to the second DC output terminal. The power electronics converter may alternatively comprise an H-bridge converter for each phase, in which the branch is a first branch, the power electronics converter comprising a second branch comprising first and second semiconductor switches connected in series between the first and second DC output terminals, the second input terminal connected to a node between the first and second semiconductor switches of the second branch.

The power electronics converter may be rated to convert over 30 kW of electrical power.

The power electronics converter may comprise a plurality of said branches connected between the first and second DC output terminals, the node between the first and second semiconductor switches of each branch being connectable to a respective phase of an electrical machine.

According to a third aspect there is provided an electrical power system comprising an electrical machine, a DC network and a power electronics converter according to the first or second aspect, the electrical machine connected to the node of the power electronics converter and the DC network connected across the first and second output terminals.

The electrical machine may comprise a plurality of phases and the power electronics converter a respective plurality of branches, each phase of the electrical machine connected to the node between the first and second semiconductor switches of a respective branch of the power electronics converter.

The electrical machine may for example comprise three phases. The power electronics converter may comprise three branches.

The electrical power system may comprise a controller configured to provide switching signals to each switch of the power electronics converter.

The controller may be configured to detect a DC fault in the DC network and, upon detecting the DC fault, open each of the semiconductor switches until a detected DC level across the DC network falls below a predefined threshold.

According to a fourth aspect, there is provided an aircraft power and propulsion system comprising: a gas turbine engine; and an electrical power system according to the second aspect. The electrical machine of the electrical power system is mechanically coupled with a spool of the gas turbine engine.

The power electronics converter may be a unidirectional AC to DC converter (i.e., a rectifier) or a bidirectional AC-DC converter capable of operating as either a rectifier or an inverter depending on an operating mode of the electrical machine.

According to a fifth aspect, there is provided an aircraft comprising the power and propulsion system of the fourth aspect. The aircraft may be a solely gas-turbine-powered aircraft (e.g., a more electric aircraft) or a hybrid electric aircraft.

The skilled person will appreciate that except where mutually exclusive, a feature described in relation to any one of the above aspects may be applied mutatis mutandis to any other aspect. Furthermore, except where mutually exclusive, any feature described herein may be applied to any aspect and/or combined with any other feature described herein.

## BRIEF DESCRIPTION OF THE DRAWINGS

Embodiments will now be described by way of example only with reference to the accompanying drawings, which are purely schematic and not to scale, and in which:

FIG. 1 shows a general arrangement of a turbofan engine for an aircraft;

FIG. 2A is a schematic illustration of a hybrid electric aircraft propulsion system;

FIG. 2B illustrates an electrically powered propulsor such as may be used in a hybrid electric propulsion system;

FIG. 3A is a schematic circuit diagram of an example single phase AC:DC converter;

FIG. 3B is a schematic circuit diagram of an example electrical power system with a three phase AC:DC converter;

FIG. 4 is a schematic circuit diagram illustrating the effect of a DC network fault on an AC-DC converter;

FIG. 5 is a schematic circuit diagram illustrating the effect of a DC network fault on an AC-DC converter;

FIG. 6 is a schematic circuit diagram of an example electrical power system comprising a three-phase AC:DC converter with a fault across the DC network;

FIG. 7 is a schematic plot of voltage and current for an example electrical power system of the type in FIG. 6 following a DC short circuit fault;

FIG. 8 is a schematic circuit diagram of an example semiconductor switch and associated switching circuit for desaturation protection;

FIG. 9 is a schematic circuit diagram of an example semiconductor switch and associated switching circuit for reverse desaturation protection;

FIG. 10 is a schematic circuit diagram of an example electrical power system comprising a three-phase AC:DC converter with a fault across the DC network;

FIG. 11 shows a Rogowski coil and integrator providing both rate of change of current and current measurements;

FIG. 12 is a series of example plots of voltage, current, differential current and change in current over time following a fault across the DC network for the electrical power system of FIG. 10;

FIG. 13 is an example plot of DC voltage over time following a DC network fault;

FIG. 14a is an example plot of DC link voltage over time following a DC network fault;

FIG. 14b is an example plot of an output from a Rogowski coil measuring differential current through a DC output terminal following a DC network fault; and

FIG. 14c is an example plot of an integrated output from the Rogowski coil output of FIG. 14b.

## DETAILED DESCRIPTION

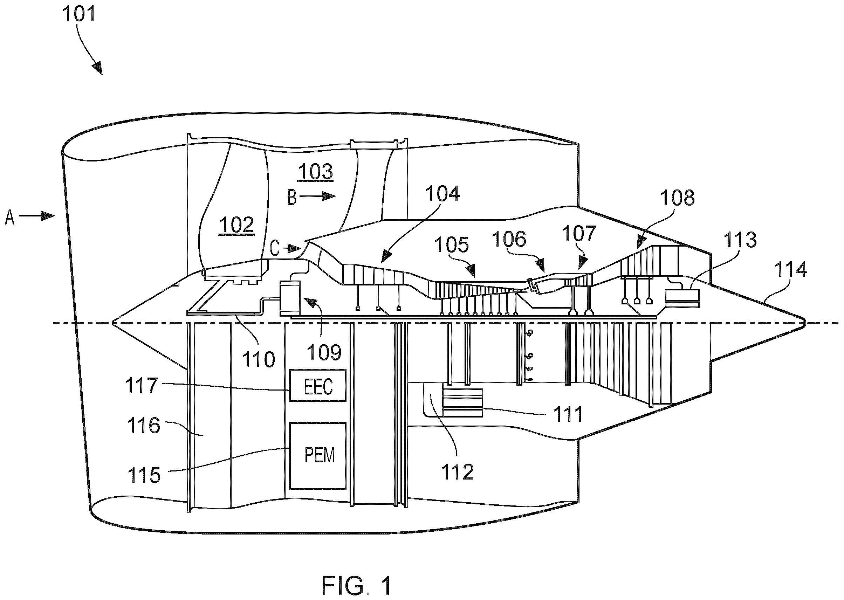

A general arrangement of an engine 101 for an aircraft is shown in FIG. 1. The engine 101 is of turbofan configuration, and thus comprises a ducted fan 102 that receives intake air A and generates two pressurised airflows: a bypass flow B which passes axially through a bypass duct 103 and a core flow C which enters a core gas turbine.

The core gas turbine comprises, in axial flow series, a low-pressure compressor 104, a high-pressure compressor 105, a combustor 106, a high-pressure turbine 107, and a low-pressure turbine 108.

In operation, the core flow C is compressed by the low-pressure compressor 104 and is then directed into the high-pressure compressor 105 where further compression takes place. The compressed air exhausted from the high-pressure compressor 105 is directed into the combustor 106 where it is mixed with fuel and the mixture is combusted. The resultant hot combustion products then expand through, and thereby drive, the high-pressure turbine 107 and in turn the low-pressure turbine 108 before being exhausted to provide a small proportion of the overall thrust.

The high-pressure turbine 107 drives the high-pressure compressor 105 via an interconnecting shaft. The low-pressure turbine 108 drives the low-pressure compressor 104 via another interconnecting shaft. Together, the high-pressure compressor 105, high-pressure turbine 107, and associated interconnecting shaft form part of a high-pressure spool of the engine 101. Similarly, the low-pressure compressor 104, low-pressure turbine 108, and associated interconnecting shaft form part of a low-pressure spool of the engine 101. Such nomenclature will be familiar to those skilled in the art. Those skilled in the art will also appreciate that whilst the illustrated engine has two spools, other gas turbine engines have a different number of spools, e.g., three spools.

The fan 102 is driven by the low-pressure turbine 108 via a reduction gearbox in the form of a planetary-configuration epicyclic gearbox 109. Thus in this configuration, the low-pressure turbine 108 is connected with a sun gear of the gearbox 109. The sun gear is meshed with a plurality of planet gears located in a rotating carrier, which planet gears are in turn meshed with a static ring gear. The rotating carrier drives the fan 102 via a fan shaft 110. It will be appreciated that in alternative embodiments a star-configuration epicyclic gearbox (in which the planet carrier is static and the ring gear rotates and provides the output) may be used instead, and indeed that the gearbox 109 may be omitted entirely so that the fan 102 is driven directly by the low-pressure turbine 108.

It is increasingly desirable to facilitate a greater degree of electrical functionality on the airframe and on the engine. To this end, the engine 101 of FIG. 1 comprises one or more rotary electrical machines, generally capable of operating both as a motor and as a generator. The number and arrangement of the rotary electrical machines will depend to some extent on the desired functionality. Some embodiments of the engine 101 include a single rotary electrical machine 111 driven by the high-pressure spool, for example by a core-mounted accessory drive 112 of conventional configuration. Such a configuration facilitates the generation of electrical power for the engine and the aircraft and the driving of the high-pressure spool to facilitate starting of the engine in place of an air turbine starter. Other embodiments, including the one shown in FIG. 1, comprise both a first rotary electrical machine 111 coupled with the high pressure spool and a second rotary electrical machine 113 coupled with the low pressure spool. In addition to generating electrical power and the starting the engine 101, having both first and second rotary machines 111, 113, connected by power electronics, can facilitate the transfer of mechanical power between the high and lower pressure spools to improve operability, fuel consumption etc.

As mentioned above, in FIG. 1 the first rotary electrical machine 111 is driven by the high-pressure spool by a core-mounted accessory drive 112 of conventional configuration. In alternative embodiments, the first electrical machine 111 may be mounted coaxially with the turbomachinery in the engine 101. For example, the first electrical machine 111 may be mounted axially in line with the duct between the low- and high-pressure compressors 104 and 105. In FIG. 1, the second electrical machine 113 is mounted in the tail cone 114 of the engine 101 coaxially with the turbomachinery and is coupled to the low-pressure turbine 108. In alternative embodiments, the second rotary electrical machine 113 may be located axially in line with low-pressure compressor 104, which may adopt a bladed disc or bladed drum configuration to provide space for the second rotary electrical machine 113. It will of course be appreciated by those skilled in the art that any other suitable location for the first and (if present) second electrical machines may be adopted.

The first and second electrical machines 111, 113 are connected with power electronics. Extraction of power from or application of power to the electrical machines is performed by a power electronics module (PEM) 115. In the present embodiment, the PEM 115 is mounted on the fan case 116 of the engine 101, but it will be appreciated that it may be mounted elsewhere such as on the core of the gas turbine, or in the vehicle to which the engine 101 is attached, for example.

Control of the PEM 115 and of the first and second electrical machines 111 and 113 is in the present example performed by an engine electronic controller (EEC) 117. In the present embodiment the EEC 117 is a full-authority digital engine controller (FADEC), the configuration of which will be known and understood by those skilled in the art. It therefore controls all aspects of the engine 101, i.e., both of the core gas turbine and the first and second electrical machines 111 and 113. In this way, the EEC 117 may holistically respond to both thrust demand and electrical power demand.

The one or more rotary electrical machines 111, 113 and the power electronics 115 may be configured to output to or receive electric power from one, two or more dc busses. The dc busses allow for the distribution of electrical power to other engine electrical loads and to electrical loads on the airframe.

Those skilled in the art will appreciate that the gas turbine engine 101 described above may be regarded as a 'more electric' gas turbine engine because of the increased role of the electrical machines 111, 113 compared with those of conventional gas turbines.

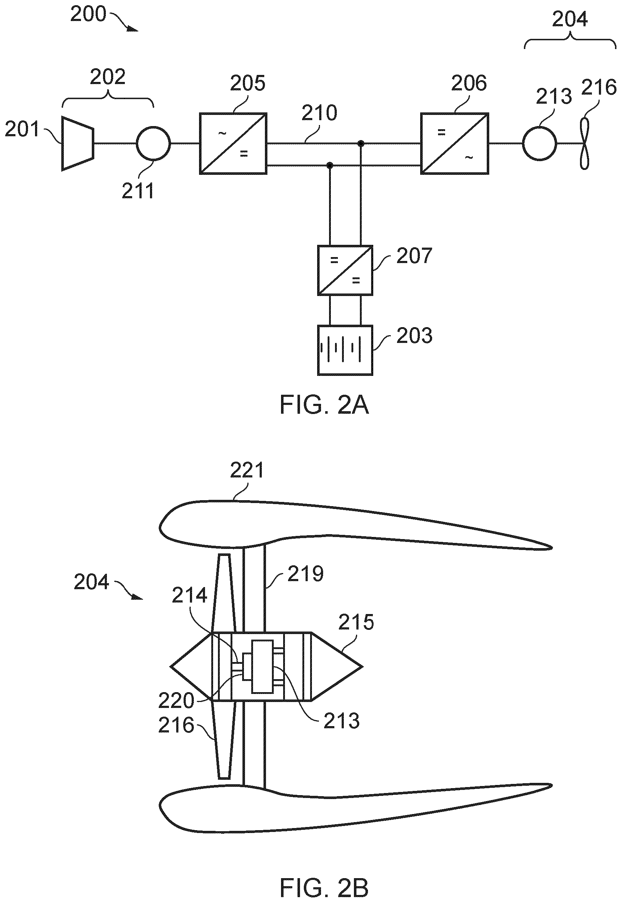

FIG. 2A illustrates an exemplary propulsion system 200 of a hybrid electric aircraft. The propulsion system 200 includes a generator set 202 comprising a gas turbine engine 201 and electrical generator 211, and a battery pack 203. Both the generator set 202 and the battery pack 203 are used as energy sources to power a motor-driven propulsor 204, an example of which is shown in FIG. 2B.

The illustrated propulsion system 200 further comprises an AC/DC converter 205, a dc distribution bus 210, a DC/AC converter 206 and a DC/DC converter 207. It will be appreciated that whilst one generator set 202 and one propulsor 204 are illustrated in this example, a propulsion system 200 may include more than one generator set 202 and/or one or more propulsor 204.

A shaft or spool of the engine 201 is coupled to and drives the rotation of a shaft of the generator 211 which thereby produces alternating current. The AC/DC converter 205, which faces the generator 211, converts the alternating current into direct current which is fed to various electrical systems and loads via the dc distribution bus 210. These electrical systems include non-propulsive loads (not shown in FIG. 2A) and the motor-driven propulsor 204, which comprises a motor 213 which drives a propulsor 204 via the DC/AC converter 206.

The battery pack 203, which may be made up of a number of battery modules connected in series and/or parallel, is connected to the dc distribution bus 210 via the DC/DC converter 207. The DC/DC converter 207 converts between a voltage of the battery pack 203 and a voltage of the dc distribution bus 210. In this way, the battery pack 203 can replace or supplement the power provided by the generator set 202 (by discharging and thereby feeding the DC distribution bus 210) or can be charged using the power provided by the generator set 202 (by being fed by the dc distribution bus 210).

Referring to FIG. 2B, in this example the propulsor 204 takes the form of a ducted fan. The fan 216 is enclosed within a fan duct 219 defined within a nacelle 221 and is mounted to a core nacelle 215. The fan 216 is driven by the electrical machine 213 via a drive shaft 214, both of which may also be thought of as components of the propulsor 204. In this embodiment a gearbox 220 is provided between the electrical machine 213 and the drive shaft 214.

The electrical machine 213 is supplied with electric power from a power source, for example the generator set 202 and/or the battery 203 via the dc bus 210. The electrical machine 213 of the propulsor, and indeed the electrical machine 211 of the generator set 202, may be of any suitable type, for example of the permanent magnet synchronous type.

Those skilled in the art will recognise the propulsion system 200 of FIGS. 2A-B to be of the series hybrid type. Other hybrid electric propulsion systems are of the parallel type, while still others are of the turboelectric type or have features of more than one type. The configuration of the more electric engine 101 of FIG. 1 may be considered similar to a parallel hybrid system, with the main distinction being the roles of the electrical machines. For example, the electrical machines of a more electric engine are generally only used in motor mode to start the engine and to improve engine operability, whereas the electric machines of a parallel hybrid propulsion system are used to motor the spools to meaningfully add to the amount of propulsive thrust produced by the turbomachinery.

Those skilled in the art will also appreciate that the hybrid architecture illustrated in FIG. 2A is only one example, and other architectures are known and will occur to those skilled in the art.

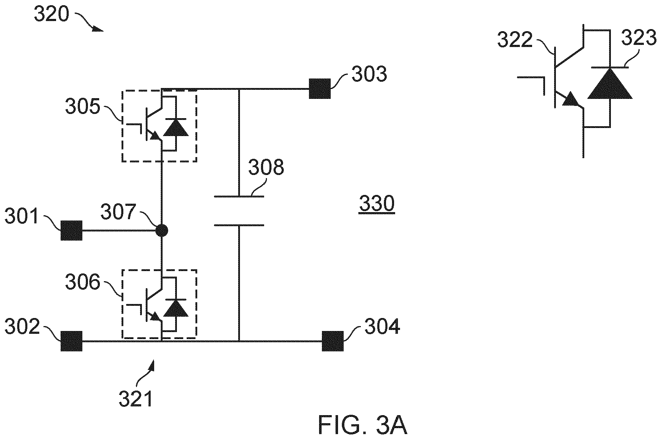

FIG. 3A illustrates an example power electronics converter 320 for converting an input AC or DC supply to an output DC supply or vice versa. The power electronics converter 320 comprises first and second input terminals 301, 302 for connection to an AC or DC supply and first and second DC output terminals 303, 304 for connection to a DC network 330. A branch 321 between the DC output terminals 303, 304 comprises first and second semiconductor switches 305, 306 connected in series between the first and second DC output terminals 303, 304. The first input terminal 301 is connected to a node 307 between the first and second switches 305, 306. In the example illustrated in FIG. 3A, the second input terminal 302 is connected to the second DC output terminal 304.

A DC link capacitor 308 is connected between the first and second DC output terminals 303, 304 for smoothing the DC voltage across the DC network 330.

Each of the switches 305, 306 comprises a transistor 322 and reverse-biased diode 323, as also illustrated in FIG. 3A. The transistors may be IGBTs or may be bi-directional MOSFETs. The MOSFETs may be wide-bandgap MOSFETs comprising Silicon Carbide (SiC), though other suitable materials such as Gallium Nitride (GaN) or Gallium Arsenide (GaAs) could be used instead.

As will be understood by those skilled in the art, MOSFETs inherently have a diode character. This is usually referred to as the "body diode" or "weak body diode" of a MOSFET, and it is common to illustrate the body diode in a circuit illustration of a MOSFET. The diodes 323 illustrated in FIGS. 3A and 3B may therefore represent the body diode of a MOSFET, connected in parallel with the main transistor element 322 of the MOSFET. The switch thereby provides a bi-directional switchable conduction path between the source and drain terminals of the transistor 322. Each switch may alternatively comprise, in addition to its MOSFET with associated body diode, an additional separate reverse biased diode connected across the MOSFET. Omitting the separate diodes reduces component count and system mass but limits the MOSFET current carrying capacity.

The power electronics converter 320 illustrated in FIG. 3A may comprise part of a power electronics converter 320 having multiple phases. FIG. 3B shows an example electrical power system 300 comprising an electrical machine 310 and a DC network 330 with a power electronics converter 320 of the type illustrated in FIG. 3A but comprising multiple phases. The power electronics converter 320 comprises a plurality of branches 321a-c, each branch having first and second switches 305a-c, 306a-c of the type described above in relation to FIG. 3A. A node 307a-c of each branch, corresponding to the first input terminal 301 of FIG. 3A, is connected to a respective phase of the electrical machine 310, which in the illustrated example is an AC motor or generator having a corresponding number of phases, in this case three phases. The second input terminal 302 of FIG. 3A corresponds to the second DC output terminal 304 of FIG. 3B, which is connected to the source connection of each of the second semiconductor switches 306a-c.

A controller 340 controls operation of the power electronics converter 320, principally by controlling the switching operation of each of the switches 305a-c, 306a-c. During normal operation, the controller 340 uses PWM control signals to commutate current between the diode of the first switch 305a-c of each branch 321a-c and the transistor (MOSFET) of the second switch 306a-c of each branch 321a-c. The DC network 330 provides the voltage required to reverse bias the diodes in the first switches 305a-c to allow for commutation of the AC current supplied by the electrical machine 310. This mode of operation does not make use of the bi-directional current carrying capability of MOSFETs when used in the switches 305a-c, 306a-c.

In an alternative mode of operation, which makes use of the bi-directional current capability of MOSFETs, the body diodes of each MOSFET are not used to conduct a majority of the current, although may conduct transiently during the very short commutation period. Current is commutated between the MOSFET of the first switches 305a-c conducting in a first direction (in this case the 'reverse' direction of the MOSFET) and the MOSFET of the second switches 306a-c conducting in a second opposite direction (in this case the 'forward' direction of the MOSFET). The controller 340 may switch between these two modes depending on the operating conditions of the electrical power system 300. For example, at lower operating currents (which may correspond to light loading of the DC network) the controller 340 may control the converter 320 to commutate current between the body diodes and MOSFETs, and switch to synchronous rectification mode once the operating current exceeds a predetermined limit.

It should be appreciated that the electrical power system 300 can also be operated in the synchronous rectifier mode, i.e., bi-directional conduction of the MOSFETs without conduction through the separate diodes, if present. However, higher switching frequencies may be attainable using the diodes so synchronous rectification may be less desirable in this system.

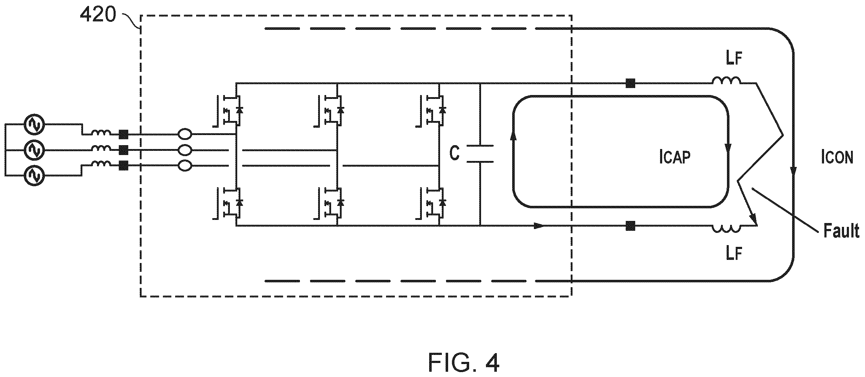

FIG. 4 illustrates a fault response of a six-switch AC to DC converter 420, which can operate as a rectifier or inverter. In the event of a pole-to-pole fault within the DC network, two components of fault current flow from the converter DC link capacitor and AC electrical system to the fault site. The first component, $I_{CAP}$, is a large discharge current created by the fast discharge of the converter DC capacitor. This current may be of the order of tens of thousands of Amperes but typically only lasts for 10s to 100s of microseconds. It is known that reversal of the DC voltage created by the capacitor discharge can cause the converter diodes (or MOSFET body diodes) to turn-on in an uncontrolled manner and conduct this very large current, which in turn may lead to converter damage. The second component, $I_{CON}$, is continuous and supplied to the fault site from the AC system, which may for example be a permanent magnet generator. This is rectified by the action of the AC-to-DC converter and is in practice limited by the impedance of the generator. This "follow-through" current is typically 10s to 100s of Amperes dependent on the rating of the generator and switching operation of the converter.

FIG. 5 illustrates a modification to the converter 420 of FIG. 4 in which an additional diode 509 is connected across the DC terminals in parallel with the DC capacitor. This serves to protect the body diodes of the converter against the high surge current stress delivered from the discharged DC capacitor. A further modification may be made to turn ON all the MOSFETs to share the initial high pulse current from discharge of the DC capacitor between the converter diodes and the reverse conducting MOSFETS. Further details of these modifications are disclosed in EP 4283851 A1.

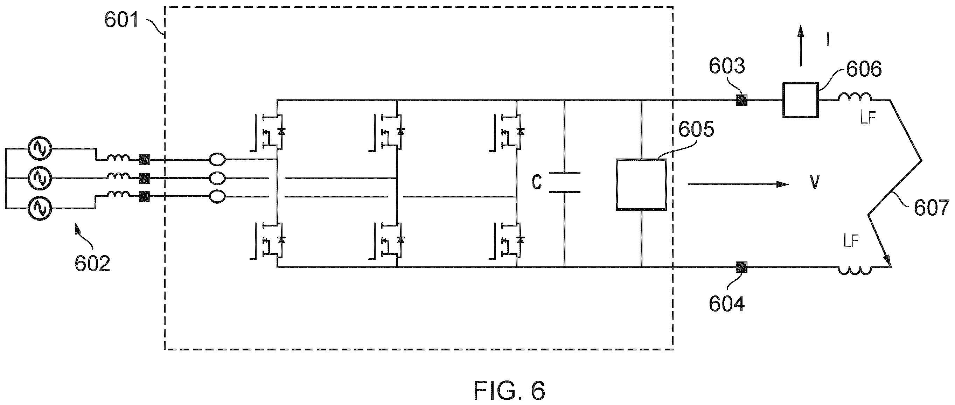

A typical method of detecting the presence of a DC network fault to enable optimum control of the converter transistor switching and isolation, for example to control opening of DC contactors, is to measure the voltage and/or current at the connection point with the DC electrical system. An example of this arrangement is illustrated in FIG. 6, in which an AC:DC converter 601 converts a three-phase AC supply from a three-phase generator 602 to a DC supply across a load connected between DC output terminals 603, 604. A voltage sensor 605 measures a DC voltage V between the DC output terminals 603, 604 and a current sensor 606 measures a current I flowing through the load. An inductance in the connection to the DC load is indicated by inductors $L_F$ either side of the DC network fault 607.

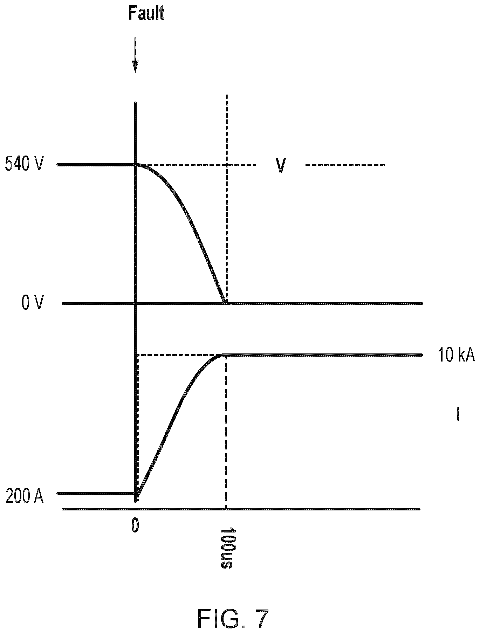

FIG. 7 illustrates schematically the effect of a short circuit fault 607 occurring across the DC terminals 603, 604 of the converter 601 in FIG. 6. Within around 100 $\mu$s, the voltage across the load falls from 540 V to near zero while the current rises from around 200 A to around 10kA. Conventional external monitoring followed by signalling to the converter controller and then onwards to the MOSFET gate drivers to initiate turn-on of the MOSFETs of the converter 601 may be too slow to prevent this high rise in current.

While detection of the type of fault illustrated in FIGS. 4 and 5 using the collapse in the DC network voltage may offer a simple and robust method, the use of current is more difficult for two main reasons. Firstly, the second component of current ($I_{CON}$ in FIG. 4) may be similar in magnitude to normal operation, for example if a high impedance generator is used, and therefore may offer no indication of a fault condition. Secondly, the first component ($I_{CAP}$) may be used to detect the fault but the sensor, which is normally used for converter control purposes, would need to measure accurately over the normal current range, typically between 0-200A, and also must be designed to measure direct current without saturating any magnetic parts contained within the sensor, which is difficult if current transformers are used. During a fault, the first component of current could change rapidly, for example within around 100 $\mu$s, to a value of over 20 times the normal current rating, meaning the sensor would need to have a high bandwidth, i.e. a fast measurement capability, and also be able to operate with a large over-current without saturation, leading to the need for complex and expensive current sensing technology.

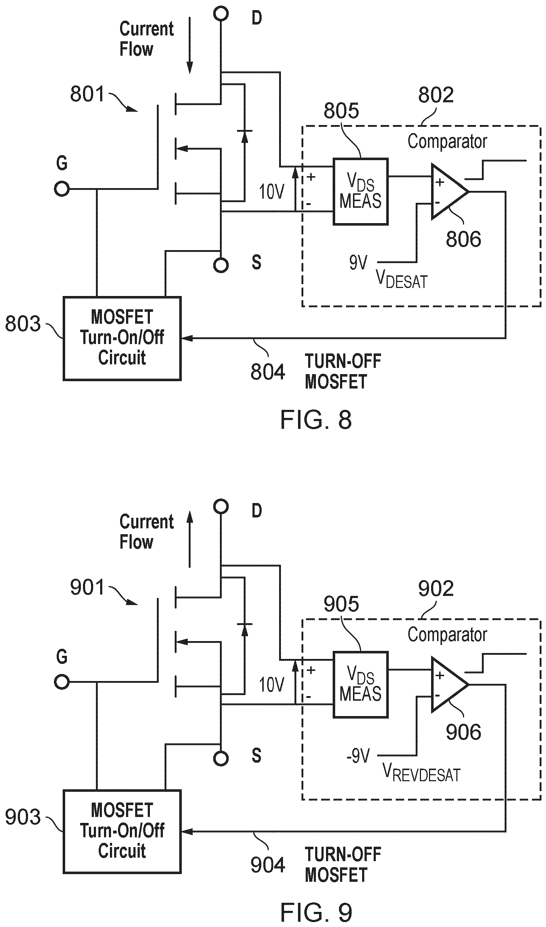

FIG. 8 is a schematic circuit diagram of a semiconductor switch 801 an associated measurement and control circuitry for a converter of the type described above. The semiconductor switch 801 is connected to a measurement circuit 802 and gate driver circuit 803. The measurement circuit 802 is connected to measure a drain-source voltage $V_{DS}$ of the switch 801 and output a control signal 804 to turn off the switch 801 if the drain-source voltage $V_{DS}$ has a value greater than a predetermined voltage threshold, thereby providing desaturation protection for the switch 801. In the example illustrated in FIG. 8, the measurement circuit 802 comprises a voltage measurement circuit 805 and a comparator 806. The voltage measurement circuit 805 measures the drain-source voltage $V_{DS}$ across the switch 801 and provides a measurement signal to a non-inverting first input of the comparator 806. An inverting second input of the comparator 806 is connected to a preset desaturation voltage source $V_{DESAT}$, which in this case is set to 9V. If the drain-source voltage $V_{DS}$ exceeds the desaturation voltage $V_{DESAT}$, such as when a high forward current is passing through the switch 801, the comparator provides the control signal 804 to the gate control circuit 803 and the switch 801 is quickly turned off.

In the case of a high reverse current flow in the body diodes, the drain-source $V_{DS}$ assumes a large negative voltage, for example -9V, meaning that a complementary protection function can be incorporated within the gate-driving circuitry. This can be considered to be a "reverse" desaturation protection, which responds to a high negative $V_{DS}$ value and instead turns the switch on, differentiating itself from the traditional desaturation protection which responds to a high positive $V_{DS}$ and turns the MOSFET off. Furthermore, by setting the negative $V_{DS}$ threshold accordingly high, this type of protection will not respond to normal rated current flow in the body diodes, which happens at each commutation event during the dead-time, typically around $1\mu s$, which would only lead to $V_{DS}$ of -3V to -4V. An example of such an arrangement is illustrated in FIG. 9, in which a semiconductor switch 901 for a converter of the type described above is connected to a measurement circuit 902 and a gate driver circuit 903. The measurement circuit 902 is connected to measure a drain-source voltage $V_{DS}$ of the switch 901 and output a control signal 904 to turn on the switch 901 if the drain-source voltage $V_{DS}$ has a negative value greater than a predetermined voltage threshold, thereby providing reverse desaturation protection for the switch 901.

In the example illustrated in FIG. 9, the measurement circuit 902 comprises a voltage measurement circuit 905 and a comparator 906. The voltage measurement circuit 905 measures the drain-source voltage $V_{DS}$ across the switch 901 and provides a measurement signal to an inverting first input of the comparator 906. A non-inverting second input of the comparator 906 is connected to a preset reverse desaturation voltage source $V_{REVDESAT}$, which is set to a negative voltage, in this case -9V. If the drain-source voltage $V_{DS}$ exceeds this value, i.e. has a negative value greater than the preset negative voltage $V_{REVDESAT}$, the comparator 906 provides the control signal 904 to the gate control circuit 903 and the switch 901 is quickly turned on.

In both the above examples of normal desaturation protection in FIG. 8 and reverse desaturation protection in FIG. 9, high frequency noise suppression filtering may be incorporated to prevent spurious MOSFET switching, although this will not detract from the ability of the circuits to respond almost instantaneously, i.e. in less than 100 $\mu s$, in practice.

The measurement and gate driver circuits may be incorporated into a power electronics converter 320 of the type illustrated in FIG. 3A or 3B, i.e. in a single phase or multi-phase converter. With reference to FIG. 3A, a measurement circuit 902 is connected to each of the first and second semiconductor switches 305, 306 to measure a drain-source voltage of the semiconductor switches 305, 306 and output a control signal 904 for the respective semiconductor switch 305, 306 if the measured drain-source voltage has a negative value greater than a predetermined voltage threshold. The predetermined voltage threshold may for example be around -9V or greater. A gate driver circuit 903 is connected to a gate and source of each of the first and second semiconductor switches 305, 306. The gate driver circuit 903 is configured to provide a gate driving signal to turn on the respective first and second semiconductor switches 305, 306 upon receiving the control signal 904 from the respective drain-source measurement circuit.

A corresponding arrangement of measurement and gate driver circuits may be implemented in a multi-phase converter 320 of the type illustrated in FIG. 3B, in which each of the switches 305a-c, 306a-c has corresponding measurement and gate driver circuits connected to turn on the switch if a negative $V_{DS}$ is measured above the predetermined threshold.

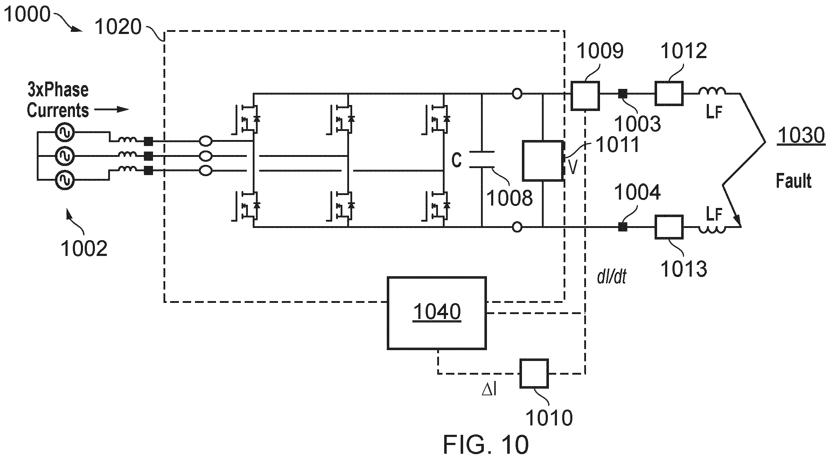

As an alternative, or in addition to, the reverse desaturation protection described above, the power electronics converter may employ detection of a differential current through one or both of the DC terminals. FIG. 10 illustrates an example electrical power system 1000 comprising a power electronics converter 1020 connected to an electrical machine 1002, in which a differential current sensor 1009 is connected to measure current through a first DC terminal 1003. The differential current sensor may alternatively be connected to measure current through the second DC terminal 1004. The converter 1000 may otherwise be similar to the converter 320 described above in relation to FIG. 3B.

The differential current sensor 1009 may be in the form of a Rogowski coil, connected to measure current through either one (or both) of the DC terminals 1003, 1004 at their connection to the DC network 1030. The converter 1020 may further comprise an integrator 1010 that receives an output from the Rogowski coil 1009.

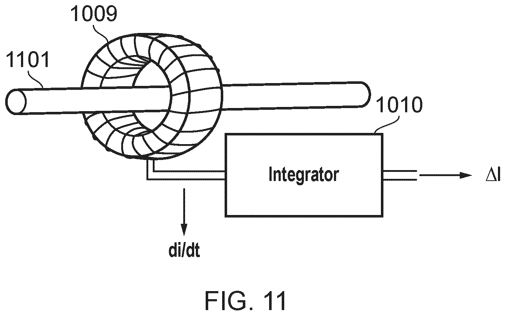

FIG. 11 illustrates an example Rogowski coil 1009 around a conductor 1101, with an output of the Rogowski coil 1009 connected to an integrator 1010 to convert the differential current measurement di/dt into a current change measurement $\Delta I$. Both measurements may be used to determine a fault state of the converter 1020.

A controller 1040 for the converter 1020 is connected to receive an output from the differential current sensor 1009 and optionally also from the integrator 1010. The controller 1040 is configured to operate the converter switches according to a fault state indicated by an output from the sensor 1009.

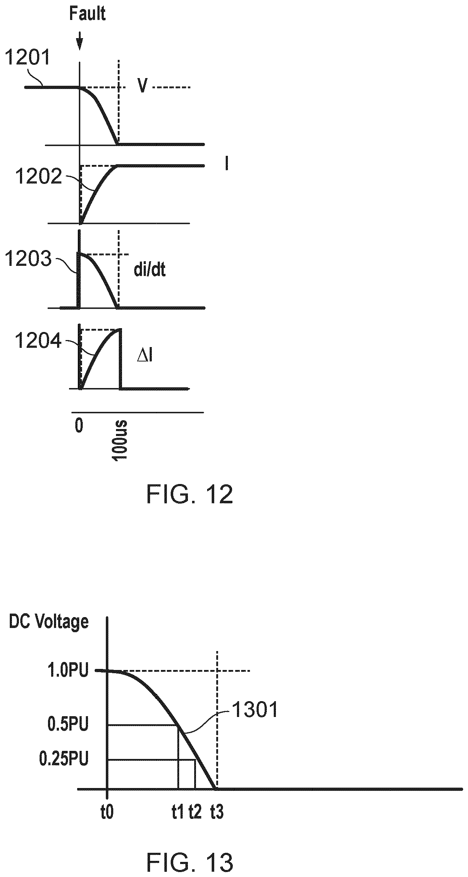

FIG. 12 illustrates schematically the effect of a short circuit fault in the DC network 1030 on the voltage across the DC terminals 1003, 1004 and current through the terminals. As described above in relation to FIG. 7, the voltage 1201 rapidly falls from a nominal value of 540V to near zero within around 100 μs and the current 1202 rises within the same period from around 200 A to around 10 kA. Also shown in FIG. 12 is a differential current di/dt 1203 and a current change ΔI 1204, which may be respectively measured by the differential current sensor 1009 and output after integration by the integrator 1010.

The differential current sensor 1009 outputs a voltage signal that directly measures the rate of change of current, di/dt. This voltage signal can be designed and scaled to operate with the high first component of current caused by discharge of the DC link capacitor in the event of a short circuit fault across the DC network 1030. This measurement does not suffer from the saturation problems of traditional current transformers. The output voltage from the differential current sensor 1009 may also be integrated using an electronic integrator circuit 1010 to accurately provide a measurement of the transient discharge current 1204, in addition to the di/dt signal 1203, which may also be used to identify a fault condition.

The first component of the DC fault current initially follows an oscillatory profile, which is defined by the natural resonant frequency of the DC link capacitor C and the inductance $L_F$ of the closed circuit created by the fault across the DC network. This natural resonant frequency f is given by:

$$f = \frac{1}{2\pi\sqrt{L_F C}}$$

Within the first quarter cycle, the voltage collapse follows an approximate cosine waveform profile, as shown in FIG. 12, while the current rises following an approximate sinusoidal waveform profile. After the first quarter cycle, the DC voltage attempts to reverse, which turns on the diodes of the converter 1020 and bypasses the capacitor 1008 such that the oscillation stops. For the sinusoidal part of the current waveform, the highest di/dt occurs at the beginning of the discharge period. This means that, during the first stages of the fault, there is a sudden and large change in the di/dt 1203 measured by the differential current sensor 1009. This happens even before the DC voltage 1201 has reduced significantly or the fault current 1202 has increased significantly. Measuring the current differential therefore provides a useful early warning that a fault has occurred.

A simple and robust DC fault detection method may be used, which is based on using di/dt and DC voltage magnitude, as measured by a voltage sensor 1011 across the DC terminals 1003, 1004. FIG. 13 illustrates possible measurement points that may be used within the first quarter cycle of a DC network fault. At time t0, i.e. the moment the fault occurs, the current differential is at a maximum and will result in only a small change in the measured output voltage. At time t1, the current differential has fallen and the output voltage has reduced by around 50%. At time t2, the current differential is smaller and the output voltage has reduced to around 25%. At time t3, the current differential is near zero and the DC output voltage is reversing, resulting in body diode conduction.

An example fault detection strategy may follow the following sequence:

1. At time t0, a high differential current di/dt is measured by the controller from an output of the differential current sensor 1009. The controller 1040 detects from a peak in the differential current measure that a fault may have occurred. The peak may be detected by an output from the differential current sensor 1009 being above a first predetermined threshold.

2. At t1, i.e. after the detection of a fault, a moderate di/dt remains in conjunction with a reduction of the DC voltage to around 50% of its normal value, i.e. its nominal DC output voltage. The converter may at this point be configured to cause the converter 1020 to enter a "crow-bar" state to prevent the second component of current flowing to the fault site. To enter a crowbar state, the upper switches of the converter are switched to a common state while the lower switches are switched to an opposite common state. For example, referring to the example in FIG. 3B, switches 305a,b,c may be turned on while switches 306a,b,c are turned off. This forms a short-circuit across the AC terminals of the AC machine 310. Alternatively, switches 306a,b,c may be turned on while switches 305a,b,c are turned off, which also forms a short-circuit across the AC terminals of the electrical machine 310. Contactors 1012, 1013 (FIG. 10) on the DC side may be simultaneously opened. Isolation of the DC network will then occur around 10-20ms later.

3. At t2, a small di/dt remains in conjunction with a reduction of the DC voltage to 25% of its normal value. The controller 1040 may be configured to operate the converter to turn on all MOSFETs to protect their body diodes against overcurrent damage if voltage reversal is attempted.

The above is only one possible protection strategy. Other strategies may be used that initiate action at different voltage and/or di/dt measurement points. For example, step 3 could be simply based on detection of a low voltage [e.g., 0.1PU] to further reduce the MOSFET current and energy caused by the converter shoot-through transient when all MOSFETs are turned-on.

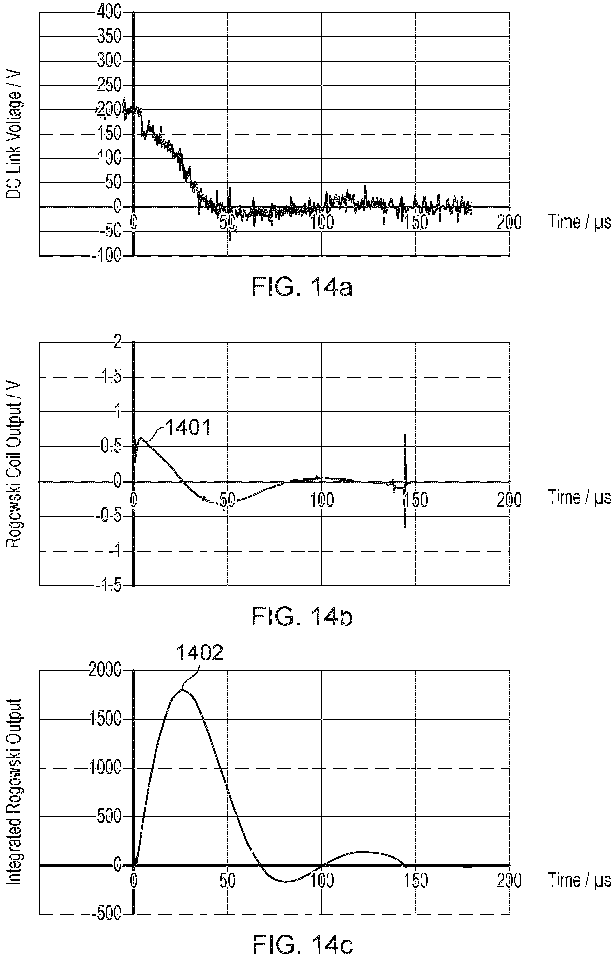

The performance of a Rogowski coil was validated in a test circuit representing the behaviour in the event of a short circuit across the DC terminals of a converter of the type described above over a 200µs period. FIGS. 14a-c show the test waveforms obtained when the fault is applied across the DC network when operating at 200V. FIG. 14a shows the DC link voltage as a function of time, FIG. 14b the Rogowski coil output voltage and FIG. 14c an integrated version of the Rogowski coil voltage. FIG. 14b in particular shows that the Rogowski coil voltage, which measures the di/dt signal, provides an early indication that a fault has occurred, initially indicated by a peak value 1401 within a few microseconds of the fault occurring. The integrator output reaches a peak value 1402 around 25 microseconds after the fault occurring.

The power electronics converters as described herein provide various advantages, including: i) a simple, robust and fast acting DC fault detection method, which may be based on two or more independent measurements; ii) an early warning of a DC fault even before the DC voltage has significantly reduced or the DC fault current has significantly increased; iii) an immediate indication, based on a differential current measurement, that a fault may have occurred; iv) additional information based on an integrated version of the di/dt signal, which can provide information on the discharge current magnitude and shape, which can help in identifying the location of the fault within the electrical power system and/or whether the fault is high or low impedance. A further advantage is that the fault current detection methods do not require complex and expensive current sensors that would be needed to operate with direct current plus the >20:1 range and fast response needed to measure the DC capacitor discharge pulse. The methods can work with high impedance generators that naturally limit fault current to 1.0 per-unit.

In summary, the present disclosure proposes two ways of rapidly detecting the presence of a fault in a DC network connected to a power electronics converter so that protective action can be taken as soon as possible.

In the first approach, gate driver control logic is controlled such that the gate driver for each semiconductor switch in the converter responds to a negative drain-source voltage that exceeds a threshold by turning ON all MOSFETs.

The second approach involves the use a differential current sensor such as a Rogowski coil to identify a DC network fault before voltage reversal occurs. By combining this measurement with a separate voltage measurement to confirm the presence of a fault, the electrical network can be safeguarded against false tripping caused by sensor malfunction or electrical noise/interference.

Although the examples described herein relate to AC: DC converters, the same principles may be applied to DC:DC converters, enabling fault detection and protective action in one or both DC networks.

Various examples have been described, each of which feature various combinations of features. It will be appreciated by those skilled in the art that, except where clearly mutually exclusive, any of the features may be employed separately or in combination with any other features and the invention extends to and includes all combinations and sub-combinations of one or more features described herein.

It should also be noted that whilst the embodiments have been described with reference to an aircraft, and to turbofan engines, it will be understood that the principles of the described electrical systems may be applied to other installations, for example to aircraft with turboprop engines, aircraft with purely electric power and propulsion systems, to marine environments such as on a naval vessel powered by gas turbines, a hybrid system or purely electric system, and to other transport applications including trains.

## Claims

1. A power electronics converter (1020) comprising:

   an input terminal;
   first and second DC output terminals (1003, 1004);
   a branch comprising first and second semiconductor switches connected in series between the first and second DC output terminals (1003, 1004), the input terminal connected to a node between the first and second semiconductor switches;
   a DC link capacitor (1008) connected between the first and second DC output terminals (1003, 1004);
   a differential current sensor (1009) arranged to measure a differential current signal through the first or second DC terminals (1003, 1004); and
   a controller (1040) configured to provide switching signals to each of the first and second switches of the power electronics converter (1020),
   wherein the controller (1040) is further configured to detect a fault in a DC network (1030) connected between the first and second DC output terminals (1003, 1004) upon detection of a peak in an output from the differential current sensor (1009) above a first predetermined threshold and operate the first and second switches to prevent current flowing to the DC network (1030).

2. The power electronics converter (1020) of claim 1, further comprising a voltage sensor (1011) connected to measure a voltage across the DC output terminals (1003, 1004), wherein the controller (1040) is configured to prevent current flowing to the DC network (1030) upon detection of the peak from the differential current sensor (1009) above the first predetermined threshold and upon detection from the voltage sensor (1011) of the voltage across the DC output terminals (1003, 1004) falling below a second predetermined threshold.

3. The power electronics converter (1020) of claim 2, wherein the second predetermined threshold is around 60% or less of a nominal DC output voltage of the converter (1020).

4. The power electronics converter (1020) of claim 2 or claim 3, wherein the controller (1040) is further configured to open contactors (1012, 1013) to disconnect the DC network (1030) from the converter after detection of the peak from the differential current sensor (1009) and detection from the voltage sensor (1011) of the voltage across the DC output terminals (1003, 1004) falling below the second predetermined threshold.

5. The power electronics converter (1020) of any one of claims 2 to 4, wherein the controller (1040) is configured to operate the converter (1020) to turn on the semiconductor switches upon detection of the voltage across the DC output terminals (1003, 1004) falling below a third predetermined threshold lower than the second predetermined threshold.

6. The power electronics converter (1020) of claim 5, wherein the third predetermined threshold is around 25% or less of a nominal DC output voltage of the converter (1020).

7. The power electronics converter (1020) of any preceding claim further comprising an integrator (1202) connected to the differential current sensor (1009) and configured to output a measure of change in current (ΔI) through the first or second DC terminals (1003, 1004), wherein the controller (1040) is configured to receive the measure of change in current (ΔI) and operate the first and second switches to prevent current flowing to the DC network (1030) upon detection of a peak in an output from the differential current sensor (1009) above a first predetermined threshold and if the measure of change in current (ΔI) is above a fourth predetermined threshold.

8. The power electronics converter (1020) of any preceding claim, wherein the differential current sensor (1009) comprises a Rogowski coil.

9. A power electronics converter (320) comprising:

    an input terminal (301);
    first and second DC output terminals (303, 304);
    a branch (321) comprising first and second semiconductor switches (305, 306) connected in series between the first and second DC output terminals (303, 304), the input terminal (301) connected to a node (307) between the first and second semiconductor switches (305, 306);
    a DC link capacitor (308) connected between the first and second DC output terminals (303, 304);
    first and second drain-source measurement circuits (902) connected to measure a drain-source voltage of the respective first and second semiconductor switches (305, 306) and output a control signal (904) for the respective semiconductor switch (305, 306) if the measured drain-source voltage has a negative value greater than a predetermined voltage threshold; and
    first and second gate driver circuits (903) connected to a gate and source of the respective first and second semiconductor switches (305, 306) and configured to provide a gate driving signal to turn on the respective first and second semiconductor switches (305, 306) upon receiving the control signal (904) from the respective drain-source measurement circuit (902).

10. The power electronics converter (320) of claim 9, wherein each drain-source measurement circuit (902) comprises a voltage measurement circuit (905) configured to measure the drain-source voltage across the respective semiconductor switch (305, 306) and a comparator (906) having an inverting first input connected to receive an output from the voltage measurement circuit (905), a non-inverting second input connected to receive a negative voltage source ($V_{REVDESAT}$) and an output connected to provide the control signal (904) to the gate driving circuit (903) if the output from the voltage measurement circuit (905) has a negative value greater than the predetermined voltage threshold from the negative voltage source ($V_{REVDESAT}$).

11. The power electronics converter (320) of claim 10, wherein the predetermined voltage threshold is around -9V or greater.

12. The power electronics converter (320, 1020) of any preceding claim, further comprising a reverse-biased DC link diode (509) connected across the DC link capacitor (308, 1008).

13. The power electronics converter (320, 1020) of any preceding claim, comprising a plurality of said branches (310a-c) connected between the first and second DC output terminals (303, 304), the node (307a-c) between the first and second semiconductor switches (305a-c, 306a-c) of each branch (310a-c) being connectable to a respective phase of an electrical machine (310).

14. An electrical power system (300, 1000) comprising:

an electrical machine (310, 1002);
a DC network (330, 1030); and
a power electronics converter (320, 1020) according to any one of claims 1 to 13,
wherein the electrical machine (310, 1002) is connected to the node (307a-c) of the power electronics converter (320, 1020) and the DC network (330, 1030) is connected across the first and second output terminals (303, 304, 1003, 1004).

15. An aircraft power and propulsion system (200) comprising:

a gas turbine engine (201); and
an electrical power system (300, 1000) according to claim 14,
wherein the electrical machine (310, 1002) of the electrical power system is mechanically coupled with a spool of the gas turbine engine (201).

FIG. 1

FIG. 2A

FIG. 2B

FIG. 3A

FIG. 3B

FIG. 4

FIG. 5

FIG. 6

FIG. 7

Current
Flow

D

801

G

10V

805

$V_{DS}$
MEAS

802

Comparator

+

−

806

9V

$V_{DESAT}$

S

803

MOSFET
Turn-On/Off
Circuit

804

TURN-OFF
MOSFET

FIG. 8

Current
Flow

D

901

G

10V

905

$V_{DS}$
MEAS

902

Comparator

+

−

906

−9V

$V_{REVDESAT}$

S

903

MOSFET
Turn-On/Off
Circuit

904

TURN-OFF
MOSFET

FIG. 9

FIG. 10

1009

1101

1010

Integrator

ΔI

di/dt

FIG. 11

FIG. 12

FIG. 13

FIG. 14a

FIG. 14b

FIG. 14c

Europäisches
Patentamt
European
Patent Office
Office européen
des brevets

# EUROPEAN SEARCH REPORT

**Application Number**

EP 25 16 2508

## DOCUMENTS CONSIDERED TO BE RELEVANT

| Category | Citation of document with indication, where appropriate, of relevant passages | Relevant to claim | CLASSIFICATION OF THE APPLICATION (IPC) |
|---|---|---|---|
| X,D | EP 4 283 851 A1 (ROLLS ROYCE PLC [GB]) 29 November 2023 (2023-11-29) | 1-8, 13-15 | INV. H02M1/00 |
| Y | * paragraph [0025] - paragraph [0090] * <br> * figures 1-10 * | 9-12 | H02M1/08 <br> H02M1/32 <br> H02M7/219 |
| A | Sueker Keith H.: "Rogowski Coils" In: "Power Electronics Design : A Practitioner's Guide", 21 September 2005 (2005-09-21), Elsevier Science & Technology, XP093137941, ISBN: 978-1-4933-0316-8 pages 237-238, * page 237 - page 238 * | 1-8 | H03K17/082 |
| A | YAN WANG ET AL: "A new method to detect the short circuit current in DC supply system based on the flexible Rogowski coil", ELECTRIC POWER EQUIPMENT - SWITCHING TECHNOLOGY (ICEPE-ST), 2011 1ST INTERNATIONAL CONFERENCE ON, IEEE, 23 October 2011 (2011-10-23), pages 237-240, XP032088691, DOI: 10.1109/ICEPE-ST.2011.6122978 ISBN: 978-1-4577-1273-9 * the whole document * | 1-8 | |
| Y | US 11 362 651 B1 (KRUG MICHAEL [DE] ET AL) 14 June 2022 (2022-06-14) * column 1, line 6 - column 4, line 2 * * column 13, line 2 - column 20, line 61 * * figures 10,11 * | 9-12 | |

**TECHNICAL FIELDS SEARCHED (IPC)**

H02M
H03K

The present search report has been drawn up for all claims

| Place of search | Date of completion of the search | Examiner |
|---|---|---|
| The Hague | 18 August 2025 | Lochhead, Steven |

CATEGORY OF CITED DOCUMENTS

X : particularly relevant if taken alone
Y : particularly relevant if combined with another document of the same category
A : technological background
O : non-written disclosure
P : intermediate document

T : theory or principle underlying the invention
E : earlier patent document, but published on, or after the filing date
D : document cited in the application
L : document cited for other reasons

& : member of the same patent family, corresponding document

EPO FORM 1503 03.82 (P04C01)

## ANNEX TO THE EUROPEAN SEARCH REPORT
## ON EUROPEAN PATENT APPLICATION NO.

EP 25 16 2508

This annex lists the patent family members relating to the patent documents cited in the above-mentioned European search report.
The members are as contained in the European Patent Office EDP file on
The European Patent Office is in no way liable for these particulars which are merely given for the purpose of information.

18-08-2025

| Patent document cited in search report | Publication date | Patent family member(s) | Publication date |
|---|---|---|---|
| EP 4283851 A1 | 29-11-2023 | EP 4283851 A1 | 29-11-2023 |
| | | US 2023373319 A1 | 23-11-2023 |
| US 11362651 B1 | 14-06-2022 | CN 115001299 A | 02-09-2022 |
| | | DE 102022104679 A1 | 08-09-2022 |
| | | US 11362651 B1 | 14-06-2022 |

EPO FORM P0459

For more details about this annex : see Official Journal of the European Patent Office, No. 12/82

**EP 4 633 018 A1**

## REFERENCES CITED IN THE DESCRIPTION

*This list of references cited by the applicant is for the reader's convenience only. It does not form part of the European patent document. Even though great care has been taken in compiling the references, errors or omissions cannot be excluded and the EPO disclaims all liability in this regard.*

**Patent documents cited in the description**

- EP 4283851 A1

**28**